**Europäisches Patentamt**

**European Patent Office**

**Office européen des brevets**

(19)

(11) Veröffentlichungsnummer: **0 201 652**
A1

## EUROPÄISCHE PATENTANMELDUNG

(12)

(21) Anmeldenummer: 85710006.9

(22) Anmeldetag: 10.05.85

(51) Int. Cl.⁴: **H 01 L 23/42**

(43) Veröffentlichungstag der Anmeldung:
20.11.86 Patentblatt 86/47

(84) Benannte Vertragsstaaten:
AT BE DE FR GB IT LU NL SE

(71) Anmelder: BBC Aktiengesellschaft Brown, Boveri & Cie.
Haselstrasse
CH-5401 Baden(CH)

(72) Erfinder: Klein, Erwin
Dresdner Strasse 5
D-6805 Heddesheim(DE)

(74) Vertreter: Kempe, Wolfgang, Dr. et al,
c/o Brown, Boveri & Cie AG Postfach 351
D-6800 Mannheim 1(DE)

(54) Siede-Kessel-Kühlung für Halbleiter, insbesondere für Leistungsstromrichter.

(57) Siede-Kessel-Kühlung für Halbleiter, insbesondere für Leistungsstromrichter, bei denen die zu kühlenden Halbleiterelemente in der Siedeflüssigkeit eingetaucht angeordnet sind und bei denen der die Verlustleistung abführende Siededampf an den von außen luftgekühlten Kesselwänden oberhalb des Siedeflüssigkeitsspiegels kondensiert. Bei gleicher Baugröße wie den bisher bekannten Kesseln soll ein Siedekessel einen bedeutend kleineren Wärmewiderstand besitzen. Dies wird dadurch erreicht, daß die Wände und die Decke des Kessels im Bereich der Kondensationszonen taschenförmig ausgebildet sind und die sich nach außen erstreckenden Taschen (16) mit Kühlrippen (22,23) versehen sind.

Fig. 4

EP 0 201 652 A1

- 1 -

B B C   A K T I E N G E S E L L S C H A F T

Brown, Boveri & Cie                    Baden/Schweiz

Mp.Nr. 555/85                          2. Mai 1985

                                       ZPT/P2-Sz/Fo

## Siede-Kessel-Kühlung für Halbleiter, insbesondere für Leistungsstromrichter

Die Erfindung bezieht sich auf Siede-Kessel-Kühlung für Halbleiter, insbesondere für Leistungsstromrichter, bei denen die zu kühlenden Halbleiterelemente eingetaucht in der Siedeflüssigkeit angeordnet sind und bei denen der die Verlustleistung abführende Siededampf an den von außen luftgekühlten Kesselwänden oberhalb des Siedeflüssigkeitsspiegels kondensiert.

Bei der Siede-Kessel-Kühlung, die sich neben der Dosenkühlung entwickelt hat, werden die Halbleiterelemente, meist bestückt mit Kühlkörpern, in der Siedeflüssigkeit eingetaucht angeordnet. Hierdurch wird auch bei kleinen Kühlflächen ein ausreichender Wärmeübergangswert erreicht. Die beim Sieden durch Umwandlung in Dampf aufgenommene Wärme wird durch Kondensation ebenso wie durch Konvektion der Siedeflüssigkeit - die Siedeflüssigkeit wird durch die Dampfphasenbildung beim Siedeprozeß bewegt - an die Kesselwandung überführt. Von dieser wird mittels Warmeleitung in metallenen Behälterwänden und anschließende Konvektion die Energie an die Kühlluft, in einigen Fallen auch an ein Zwischenmedium, wie z.B. Wasser abgegeben.

Es haben sich besonders kubische und zylindrische Behälter, beide mit Rippen zur mechanischen Steifigkeit und Vergrößerung der Kühloberfläche versehen, herausgebildet. Die Kessel sind in beiden Fällen nicht vollständig mit Kühlflüssigkeit gefüllt, um deren thermische Ausdehnung aufzunehmen und einen Kondensationsraum zur Verfügung zu haben.

Die Größe des Warmewiderstandes einer Kühleinrichtung ist ein Maß für die Effektivität des Systems bei vorgegebenem Temperaturgradienten. Die Warmeübergangswiderstände sind umgekehrt proportional dem Produkt aus Wärmeübergangszahl und -fläche. Die Wärmeübergangszahlen der Konvektionen von Flüssigkeiten und der Kondensation von Dampf sind gegenüber denen der Konvektion von Luft gewöhnlich groß. Am Beispiel des Wellrohrkessels, bei dem innen wie außen die gleichen Wärmeflachen vorliegen, ist leicht einzusehen, wie die Wärmewiderstände der Luftkonvektion dominieren gegenüber denen, die aus der Flüssigkeitskonvektion und der Dampfkondensation herrühren. Hieraus resultiert eine geringere Effektivität solcher Siedekühlkessel.

Aufgabe der Erfindung ist es, einen Siedekühlkessel zu schaffen, bei dem ohne großen Aufwand bei gleicher Baugröße wie den bisher bekannten Kesseln ein bedeutend kleinerer Wärmewiderstand erreicht werden kann.

Diese Aufgabe wird gemäß der Erfindung dadurch gelöst, daß die Wände und die Decke des Kessels im Bereich der Kondensationszonen taschenförmig ausgebildet sind und die sich nach außen erstreckenden Taschen mit Kühlrippen versehen sind. Die Taschen können nach weiteren Merkmalen der Erfindung durch spanloses Umformen aus Blech hergestellt werden, so daß sie eine mäanderförmige Form besitzen. Wennn das Bauteil durch Gießen hergestellt wird, können die Taschen Teil einer Gußkonstruktion sein. Weiterhin wird vorgeschlagen auf den Taschen noch Kühlrippen anzubringen. Wenn die Kühlrippen zusätzlich aufgesteckt werden, werden sie vorteilhaft mit Durchzügen zur großflächigen Kontaktierung versehen. Aber es ist auch möglich, die Kühlrippen anzugießen. Um eine ausreichende mechanische Steifigkeit zu erzielen, soll mindestens ein Teil der Kühlrippen mit allen Taschen kontaktieren.

Als weiteres Merkmal der Erfindung wird vorgeschlagen, die Decke des Siedekühlkessels als Deckel mit Taschen und Kühlrippen zu versehen und ihm hierdurch eine ausreichende Stabilität zu geben.

Die gemäß der Erfindung vorgeschlagene Ausbildung der Taschen in Verbindung mit Siedekühlung hat den Vorteil, daß, da der Temperaturgradient des strömenden Dampfes über große Strecken vernachlassigbar ist, die Kondensationsflachen in Strömungsrichtung gesehen, praktisch mit gleicher Temperatur beaufschlagt werden. Dies ist nicht der Fall, wenn die Wärme über metallische Leiter an die Luftkonvektionsflächen herangeführt werden.

In den Figuren ist ein Ausführungsbeispiel dargestellt.

Es zeigen:

Fig. 1    einen kubischen Kessel mit dem Deckel gemäß der Erfindung,

Fig. 2 +3 den Verlauf von Teilwarmeströmen und
Fig. 4    eine perspektivische Ansicht auf einen Kessel

mit dem Deckel gemäß der Erfindung.

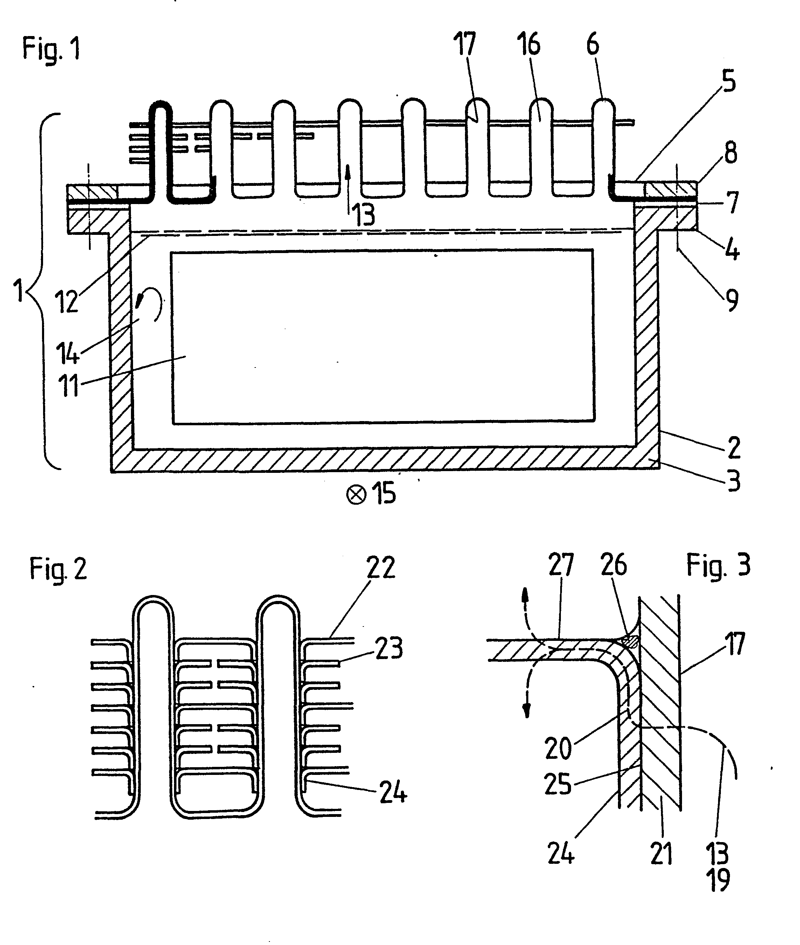

Figur 1 zeigt einen Kühlbehälter 1, der aus einem Kessel 2 und einem Deckel 5 besteht. Der Kessel 2 besteht aus der Wandung 3 und dem Flansch 4. Der Deckel 5, mit dem der Kessel 2 verschlossen wird, besteht aus einem mäanderförmig gefalteten Blech 6. Unter Zwischenlage einer Dichtung 7 wird ein Rahmen 8 durch Schrauben 9 mit dem Flansch 4 verbunden.

In dem Kessel befindet sich eine Wärmequelle 11, die ihre Wärme an die Kühlflüssigkeit 12 durch Sieden abgibt, d.h. durch Umwandlung der Flüssigkeit in Dampf. Ein Teil des Dampfes kondensiert bereits in der Flüssigkeit, welche die dabei freiwerdende Energie 14 an die Kesselwandung 3 abgibt. Von dort strömt sie durch das Metall zur Außenflache der Kesselwandung bzw. zu eventuell vorhandenen Kühlrippen am Boden des Kessels, von wo sie von der vorbeiströmenden Luft 15 aufgenommen wird. Der übrig bleibende Teil des Dampfes 13 tritt aus der Kühlflüssigkeit aus und füllt den Raum zwischen Siedeflüssigkeitsspiegel und Deckel.

Im Deckel sind durch die Formgebung Taschen 16 entstanden an deren Innenwandung 17 der aufsteigende Dampf 13 kondensiert. Die im Dampf enthaltende Energie 19 wird freigegeben und wird mittels Wärmeleitung 20 durch die Taschenwandung 21 zu den Kühlrippen 22 und 23 transportiert. Die Kühlrippen weisen Durchzüge 24 auf, wodurch an deren Außenwandung 25 eine großflächige Kontaktierung erfolgt. Hierdurch wird ein kleiner Wärmeübergangswiderstand erreicht. Auch wenn keine Tauchlötung 26 vorgenommen wird und die Kühltaschen plastisch aufgeweitet werden, bleibt der Wärmeübergangswiderstand noch klein. An den Oberflächen 27 der Kühlrippen tritt dann die Wärme großflächig zur Luft über. Es gibt zwei Gruppen von

Mp.Nr. 555/85                     5

Kü⌐lrippen. Die Kühlrippen 23 umschließen jeweils nur eine Kühltasche 16, während die Kühlrippen 22 so ausgebildet sind, daß alle Kühltaschen abgespannt werden. Mindestens zwei derartige Kühlrippen 22 bilden einen Kastentrager.

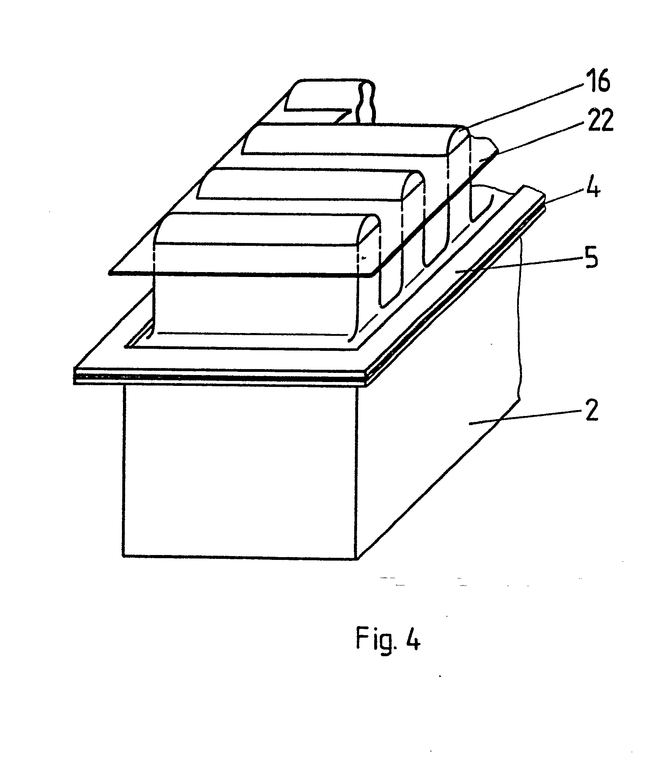

Figur 4 zeigt eine perspektivische Ansicht des Kessels mit aufgesetztem Deckel 5. Um die Anordnung der Taschen besser erkennen zu können, ist nur eine Kühlrippe 22 dargestellt worden.

A n s p r ü c h e

1. Siede-Kessel-Kühlung für Halbleiter, insbesondere Leistungsstromrichter, bei der die zu kühlenden Halbleiterelemente eingetaucht in der Siedeflüssigkeit angeordnet sind und der die Verlustleistung abführende Siededampf an den von außen luftgekühlten Kesselwänden oberhalb des Siedeflüssigkeitsspiegels kondensiert, dadurch gekennzeichnet, daß die Wände und die Decke des Kessels (1) im Bereich der Kondensationszonen taschenförmig (16) ausgebildet sind und die sich nach außen erstreckenden Taschen (16) mit Kühlrippen (22,23) versehen sind.

2. Siede-Kessel-Kühlung nach Anspruch 1, dadurch gekennzeichnet, daß die Taschen (16) durch spannloses Umformen aus Blech hergestellt sind.

3. Siede-Kessel-Kühlung nach Anspruch 1, dadurch gekennzeichnet, daß die Taschen (16) Bestandteil einer Gußkonstruktion sind.

4. Siede-Kessel-Kühlung nach einem oder mehreren der Ansprüche 1 bis 3, dadurch gekennzeichnet, daß die Kühlrippen (22,23) Durchzüge (24) zur großflächigen Kontaktierung mit den Taschen aufweisen.

5. Siede-Kessel-Kühlung nach einem oder mehreren der Ansprüche 1 bis 3, dadurch gekennzeichnet, daß die Kühlrippen (22,23) an die Taschen (16) angegossen sind.

6. Siede-Kessel-Kühlung nach einem oder mehreren der Ansprüche 1 bis 5, dadurch gekennzeichnet, daß mindestens ein Teil der Kühlrippen (22,23) mit allen

Taschen (16) kontaktiert ist zur Erzielung einer mechanischen Steifigkeit.

7. Siede-Kessel-Kühlung nach einem oder mehreren der Ansprüche 1 bis 6, dadurch gekennzeichnet, daß die Decke (5) des Siedekessels als Deckel mit Taschen (16) ausgebildet ist, die untereinander durch Kühlrippen (22,23) verbunden sind.

1/2

0201652

Fig. 1

Fig. 2

Fig. 3

16
22
4
5
2

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 266 427 (COMP. INT. POUR L'INFORMATIQUE) <br> * Figuren 2,4; Seite 2, Zeile 34 - Seite 3, Zeile 15 * | 1 | H 01 L 23/42 |
| A | | 2,4,6, 7 | |
| | --- | | |
| Y | PATENTS ABSTRACTS OF JAPAN, Band 6, Nr. 144 (E-122)[1022], 3. August 1982; & JP - A - 57 66 653 (FUJITSU K.K.) 22-04-1982 | 1 | |
| | --- | | |
| Y | US-A-4 027 728 (MITSUBISHI) <br> * Figur 3 * | 1 | |
| A | | 3,5 | RECHERCHIERTE SACHGEBIETE (Int. Cl.4) <br><br> H 01 L |
| | ----- | | |

Der vorliegende Recherchenbericht wurde für alle Patentansprüche erstellt.

| Recherchenort <br> DEN HAAG | Abschlußdatum der Recherche <br> 16-12-1985 | Prüfer <br> DE RAEVE R.A.L. |
|---|---|---|